# DEMANDE DE BREVET EUROPEEN

(11) **EP 4 575 795 A1**
(43) Date de publication de la demande: **25.06.2025**
(21) Numéro de dépôt: 24222484.8
(22) Date de dépôt: 20.12.2024
(51) Int. Cl.: G06F 11/16, G05B 19/042

(54) **SYSTÈME DE GESTION D ENTRÉES/SORTIES D'AU MOINS UNE APPLICATION AVIONIQUE ET PROCÉDÉ DE VÉRIFICATION DE FONCTIONNEMENT D'UN TEL SYSTÈME**

(30) Priorité: 22.12.2023 FR 2315099
(71) Demandeur: THALES, 92190 Meudon (FR)
(72) Inventeur: RECULEAU, Jean-Christophe, 33700 MERIGNAC (FR); CAUDOUX, Frédéric, 33700 MERIGNAC (FR)
(74) Mandataire: Lavoix

(57) **Abrégé**

La présente invention concerne un système de gestion d'entrées/sorties d'au moins une application avionique (12) comprenant au moins deux plateformes de calcul (16A) implémentées en utilisant des ressources matérielles et logicielles similaires, chaque plateforme comprenant :
- un étage primaire (21) configuré pour acquérir des signaux analogiques ;
- un étage intermédiaire (22) configuré pour traiter numériquement des signaux numériques ;
- un étage final (23) configuré pour mettre à disposition de l'application avionique (12) des données numériques ;
- un module de surveillance matérielle (61) configuré pour implémenter un test de fonctionnement, en injectant dans l'étage primaire (21) des signaux de test prédéterminés ;
- un module de surveillance logicielle (62) configuré pour acquérir des données numériques correspondant aux signaux de test injectés, et pour vérifier leur correspondance à des valeurs prédéterminées.

## Description

La présente invention concerne un système de gestion d'entrées/sorties d'au moins une application avionique.

La présente invention concerne également un procédé de vérification de fonctionnement d'un tel système.

Le domaine de l'invention est celui de l'avionique embarquée dans un aéronef.

De manière connue en soi, il existe dans ce domaine plusieurs niveaux de criticité selon les fonctions implémentées par l'avionique. La criticité est considérée à la fois d'un point de vue de l'intégrité et d'un point de vue de la disponibilité.

Généralement, les systèmes de commande de vol sont parmi les plus critiques d'un aéronef. Ces systèmes sont d'une façon générale, en charge de:
- faire l'acquisition de l'état inertiel et dynamique de l'aéronef ;
- faire l'acquisition des positions des surfaces et / ou de l'état des moteurs de l'aéronef ;
- élaborer les nouvelles consignes de position des surfaces et / ou de l'état des moteurs selon une trajectoire de consigne à suivre,

Dès lors on comprend qu'une consigne erronée, qui ne serait pas détectée, pour une surface donnée peut amener à un déséquilibre irrécupérable de l'aéronef.

Un système hautement intègre est un système dont la probabilité de générer un erronée non-détecté est extrêmement faible.

Pour obtenir un système hautement intègre, à ce jour, il existe deux grandes techniques utilisant une répartition de type commande/surveillance (ou COMmand/MONitor en anglais ou simplement COM/MON) pour assurer la démonstration qu'un dysfonctionnement isolé ne puisse pas générer un erroné non détecté.

La première technique consiste à utiliser deux plateformes de calcul dissimilaires tant au niveau matériel que logiciel et faire des comparaisons au niveau applicatif entre deux applications indépendantes dites COMmand et MONitor sur les entrées consommées. De cette façon, produire une erreur cohérente sur la même entrée fonctionnelle aux bornes de la plateforme est considéré très peu probable. Il faudrait en effet une panne matérielle ayant le même effet ou une erreur matérielle ou logicielle simultanée et cohérente sur les deux plateformes de calcul dissimilaires pour en quelque sorte leurrer l'application MONitor qui assure la comparaison entre ses propres calculs et ceux effectués par l'application COMmand. En cas de détection d'un écart de calcul entre les deux applications un mécanisme permet d'inhiber les sorties calculées par la partie COMmand.

La seconde technique consiste à utiliser deux plateformes de calcul partiellement dissimilaires. En particulier, les ressources matérielles de ces plateformes sont identiques mais leurs logiciels de base sont différents. L'analyse ou démonstration de l'absence de panne ou erreur commune porte alors uniquement sur le périmètre matériel. Ce principe repose aussi sur la comparaison par la voie MONitor des commandes calculées par la voie COMmand.

Les deux techniques présentent toutefois un certain nombre d'inconvénients.

La première technique nécessite le développement de deux types de plateformes différentes à la fois d'un point de vue matériel et d'un point de vue du logiciel de base. Elle est donc source de coûts pour le développement mais aussi pour l'industrialisation (approvisionnement, effet de volume moindre) et la maintenance.

La deuxième technique s'avère moins contraignante que la première technique mais nécessite néanmoins le développement de deux logiciels de base dissimilaires avec les coûts de maintenance associés.

On conçoit alors que chacune des deux techniques nécessite un développement important au moins au niveau logiciel et présente de ce fait un coût de développement et de maintenance important.

La présente invention a pour but de réduire le développement, notamment le développement logiciel, nécessaire pour assurer la haute intégrité d'un système. De ce fait, l'invention permet de réduire le coût associé.

À cet effet, l'invention concerne un système de gestion d'entrées/sorties d'au moins une application avionique configurée pour générer au moins une consigne intègre, le système de gestion comprenant au moins deux plateformes de calcul implémentées en utilisant des ressources matérielles et logicielles similaires, l'une des plateformes de calcul formant une chaine de commande et l'autre formant une chaine de surveillance, chaque plateforme de calcul comprenant :
- un étage primaire configuré pour acquérir des signaux analogiques et les convertir en signaux numériques;
- un étage intermédiaire configuré pour traiter numériquement les signaux numériques en formant des données numériques ;
- un étage final configuré pour mettre à disposition de l'application avionique les données numériques ;
- un module de surveillance matérielle configuré pour implémenter un test de fonctionnement des étages primaire, intermédiaire et final, en injectant dans l'étage primaire des signaux de test prédéterminés ;
- un module de surveillance logicielle configuré pour acquérir à partir de l'étage final des données numériques correspondant aux signaux de test injectés par le module de surveillance matérielle dans l'étage primaire, et pour vérifier leur correspondance à des valeurs prédéterminées.

Selon d'autres aspects avantageux de l'invention, le système comprend une ou plusieurs caractéristiques suivantes prise(s) isolément ou suivant toutes les combinaisons techniquement possibles :
- les signaux de test prédéterminés correspondent à des signaux analogiques, des signaux numériques ou des signaux discrets ;
- le module de surveillance logicielle est configuré en outre pour piloter le choix des signaux de test par le module de surveillance matérielle ;
- le module de surveillance logicielle est configuré pour vérifier la correspondance d'au moins l'un des éléments suivants des données numériques acquises à des valeurs prédéterminées :
   - authenticité ;
   - datation ;
   - intégrité ;
   - valeur attendue.
- les modules de surveillance logicielle et de surveillance matérielle sont implémentés selon des technologies différentes et indépendantes de celles des étages primaire, intermédiaire et final ;
- le module de surveillance matérielle comprend une fonction de surveillance d'exécution des tests de fonctionnement des étages primaire, intermédiaire et final, le module de surveillance logicielle étant configuré pour réactiver périodiquement la fonction de surveillance ;
- les étages primaires des plateformes de calcul différentes sont configurés pour être utilisés de façon dissymétrique.
- l'étage primaire de chaque plateforme de calcul comprend un connecteur, un module de filtrage analogique et un module de conversion des signaux d'entrée ;
l'utilisation des étages primaires des plateformes de calcul différentes de façon dissymétrique comprend au moins l'un des éléments suivants :
- attribution de points de connexion différents entre les différents connecteurs ;
- attribution de chemins de routage et/ou de filtres analogiques différents entre les différents modules de filtrage analogique ;
- utilisation dissymétrique des différents modules de conversion des signaux d'entrée ;
- l'étage intermédiaire de chaque plateforme de calcul comprend un module d'acquisition numérique, les modules d'acquisition numérique des plateformes de calcul différentes étant configurés pour être utilisés de façon dissymétrique ;
- l'utilisation des modules d'acquisition numérique des plateformes de calcul différentes de façon dissymétrique comprend un séquencement différent entre les acquisitions sur des bus numériques et les conversions analogique/numérique ;
- l'étage intermédiaire de chaque plateforme de calcul comprend un module de traitement numérique configuré pour encapsuler chaque donnée numérique de façon à pouvoir :
   - vérifier par les autres modules de la plateforme la provenance de cette donnée ;
   - vérifier par les autres modules de la plateforme l'intégrité de cette donnée ;
   - vérifier par les autres modules de la plateforme la datation de cette donnée.
- l'étage intermédiaire est configuré en outre pour encapsuler chaque donnée numérique traitée ;
   chaque plateforme de calcul comprenant en outre une application de vérification configurée pour vérifier l'encapsulation de chaque donnée reçue ;
- l'encapsulation de chaque donnée numérique comprend la formation d'un agrégat comprenant cette donnée et au moins l'un des éléments suivants :
   - un moyen d'authentification permettant d'authentifier la provenance de cette donnée ; et
   - un moyen de datation permettant de dater cette donnée et/ou de mesurer sa fraicheur ;
- l'encapsulation de chaque donnée numérique comprend en outre la formation d'une signature numérique de tout ou d'une partie de l'agrégat correspondant ;
- la signature numérique comprend un code de vérification CRC ;
- l'application de vérification est configurée pour vérifier au moins l'un des éléments suivants de chaque donnée reçue :
   - la provenance de cette donnée ;
   - l'intégrité de cette donnée ;
   - la datation de cette donnée.
- l'application de vérification est intégrée dans l'étage final ou dans l'application avionique.

L'invention concerne également un procédé de vérification de fonctionnement d'un système de gestion tel que défini précédemment ;
le procédé de vérification comprenant les étapes suivantes :
- injection dans l'étage primaire des signaux de test prédéterminés ;
- acquisition à partir de l'étage final des données numériques correspondant aux signaux de test injectés dans l'étage primaire ; et pour
- vérification de la correspondance desdites données numériques à des valeurs prédéterminées.

Alternativement ou en complément, l'invention concerne un procédé de vérification de fonctionnement d'un système de gestion tel que défini précédemment ;
le procédé comprenant les étapes suivantes :
- encapsulation de chaque donnée numérique traitée par l'étage intermédiaire ;
- vérification de l'encapsulation de chaque donnée reçue par l'application de vérification.

L'invention apparaitra plus clairement à la lecture de la description qui va suivre, donnée uniquement à titre d'exemple non limitatif et faite en référence aux dessins dans lesquels :
- [Fig.1] la figure 1 est une vue schématique d'un système de gestion selon l'invention, le système de gestion comprenant au moins deux plateformes de calcul ;
- [Fig.2] la figure 2 est une vue schématique de l'une des plateformes de calcul de la figure 1 ; et
- [Fig.3] la figure 3 est un organigramme d'un procédé de vérification selon l'invention, le procédé de vérification étant mis en oeuvre par le système de gestion de la figure 1.

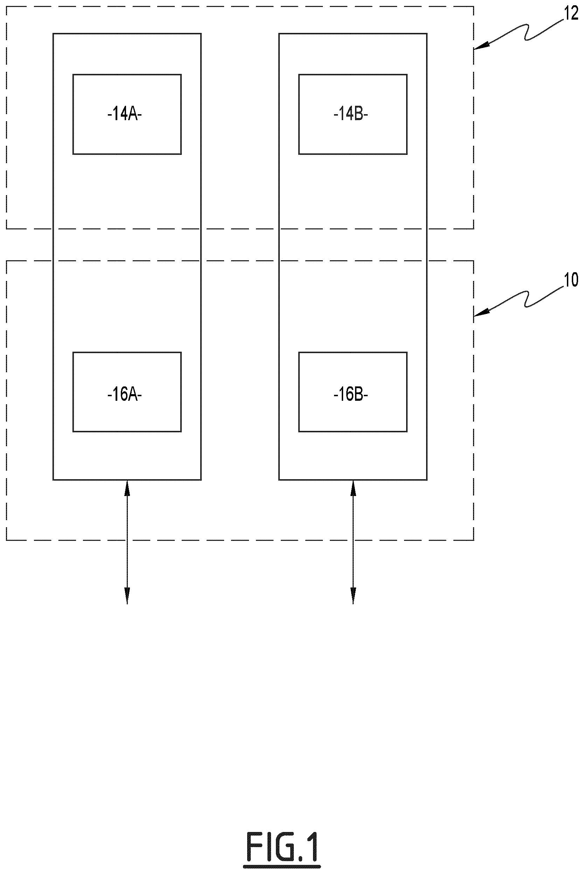

On a en effet représenté sur la figure 1 un système de gestion 10 d'entrées/sorties d'au moins une application avionique 12.

L'application avionique 12 est configurée pour générer au moins une consigne intègre destinée par exemple à un système avionique.

Par « consigne intègre », on entend une consigne dont la probabilité d'être une consigne erronée non-détectée est très faible. Cette probabilité est par exemple inférieure à 10⁻⁹ en considérant les deux chaines de commande et de surveillance, comme cela sera expliqué ci-dessous.

Avantageusement, le requis de consigne intègre appliqué à l'application avionique 12 s'accompagne aussi d'un requis de « No single failure » signifiant en français « Aucune faute ». Ce dernier requis nécessite la démonstration d'absence de mode commun entre les deux chaines de commande et de surveillance.

L'application avionique 12 met ainsi en oeuvre le fonctionnement d'un système critique d'un aéronef, comme par exemple un système de commande de vol.

Par « aéronef », on entend tout engin volant et pilotable de manière au moins partiellement automatique et/ou manuelle. Dans ce dernier cas, le pilotage de l'aéronef peut être effectué par un pilote à partir d'un cockpit de celui-ci (par exemple dans le cas d'un avion ou d'un hélicoptère) ou par un opérateur à distance (par exemple dans le cas d'un drone).

Dans le cadre d'un système hautement intègre, l'application avionique 12 met en oeuvre une chaine de commande 14A, appelée également chaine COM, et une chaine de surveillance 14B, appelée également chaine MON.

La chaine de surveillance 14B a pour objectif de surveiller le fonctionnement de la chaine de commande 14A, selon des techniques connues en soi. Ces techniques peuvent par exemple comprendre une comparaison des sorties des deux chaines 14A, 14B et lorsque ces sorties diffèrent, traiter un tel cas comme un dysfonctionnement.

Le système de gestion 10 comprend au moins deux plateformes de calcul 16A, 16B.

En particulier, le système de gestion 10 comprend une plateforme de calcul 16A, 16B pour chaque chaine de l'application avionique 12.

Chaque plateforme de calcul 16A, 16B permet de gérer les entrées et/ou les sorties de la chaine correspondante 14A, 14B de l'application 12.

Par exemple, chaque plateforme de calcul 16A, 16B est configurée pour recevoir des données, par exemple sous la forme de signaux analogiques, et pour convertir et délivrer ces données à la chaine correspondante 14A, 14B du logiciel avionique 12. Chaque plateforme de calcul 16A, 16B est configurée en outre pour recevoir des données numériques issues de la chaine correspondante 14A, 14B du logiciel avionique 12, et pour convertir et délivrer ces données à tout système intéressé par exemple sous la forme de signaux analogiques.

De manière analogue à l'application avionique 12, l'une de ces plateformes 16A, forme une chaine de commande ou simplement une chaine COM du système de gestion 10, et l'autre plateforme 16B forme une chaine de surveillance ou simplement une chaine MON du système de gestion 10.

Dans l'exemple de la figure 1, la plateforme de calcul 16A forme la chaine COM du système de gestion 10 et la plateforme de calcul 16B forme la chaine MON du système de gestion 10. La plateforme de calcul 16A est donc associée à la chaine de commande 14A de l'application avionique 12 et la plateforme de calcul 16B est associée à la chaine de surveillance 14B de l'application avionique 12.

D'autres exemples d'association de chaines de traitement, de leur nombre et de leur manière d'interaction sont également possibles.

Chaque plateforme de calcul 16A, 16B est définie par un identifiant. Un tel identifiant présente par exemple un identifiant numérique matériel avec une signature. Les identifiants de différentes plateformes de calcul 16A, 16B sont par exemple échangés au démarrage du système 10 pour une vérification de cohérence.

Selon l'invention, les plateformes de calcul 16A, 16B sont implémentées en utilisant des ressources matérielles et logicielles similaires.

Par « ressources matérielles et logicielles similaires », on entend des ressources implémentées selon une même technologie, notamment en ce qui concerne leur production, composition, langages de programmation, algorithme de fonctionnement, etc.

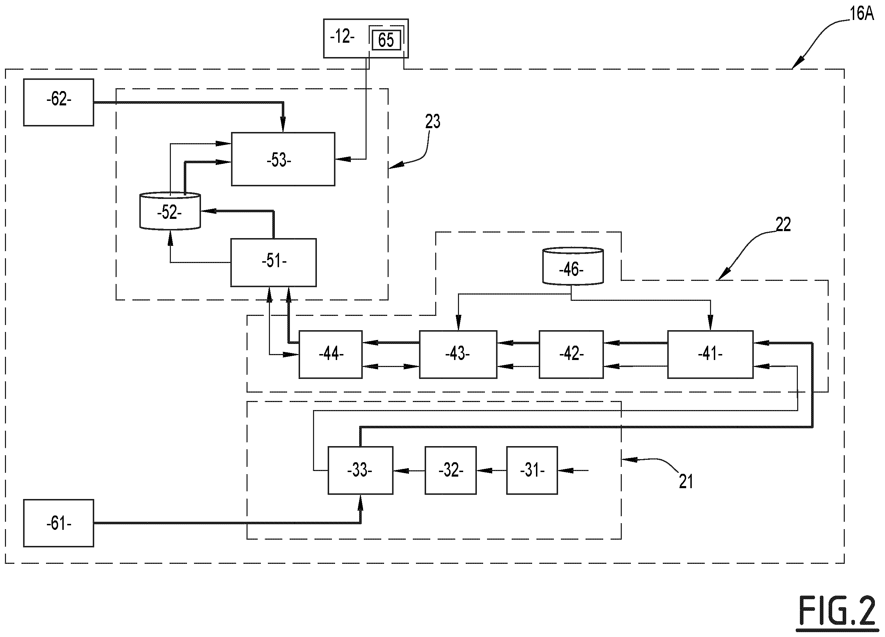

Les plateformes de calcul 16A, 16B sont donc analogues. Ainsi, par la suite, seule une plateforme, par exemple la plateforme 16A, sera expliquée plus en détail en référence à la figure 2.

Ainsi, comme cela est illustré sur la figure 2, la plateforme de calcul 16 comprend un étage primaire 21 configuré pour acquérir des signaux analogiques et les convertir en signaux numériques, un étage intermédiaire 22 configuré pour traiter numériquement les signaux numériques en formant des données numériques, et un étage final 23 configuré pour mettre à disposition de l'application avionique 12 et notamment de sa chaine 14A correspondante, les données numériques.

La composition de chacun des étages 21 à 23 est décrite ci-dessous en référence à la figure 2. Toutefois, il doit être compris que d'autres exemples de réalisation de ces étages sont également possibles.

L'étage primaire 21 comprend un connecteur 31, un module de filtrage analogique 32 et un module de conversion des signaux d'entrée 33.

Le connecteur 31 permet de connecter la plateforme 16A à tout système intéressé produisant/consommant des données, sous la forme de signaux analogiques. Par exemple, un tel système présente un ou plusieurs capteurs (par exemple capteur de position, pression, vitesse, etc.) ou une ou plusieurs surfaces contrôlables (par exemple des surfaces utilisées par les commandes de vol).

Pour ce faire, le connecteur 31 présente une pluralité de points de connexion disposés par exemple sur un support physique selon un format prédéterminé. Chacun de ces points de connexion est alors apte à recevoir/envoyer un sous-signal de type particulier. L'ensemble des sous-signaux transmis/reçus forment alors le signal analogique transmis/reçu par le connecteur 31.

Le module de filtrage analogique 32 permet d'appliquer un filtrage analogique aux signaux analogiques reçus. Ce filtrage peut comprendre un ou plusieurs filtres successifs. Par exemple, un tel filtrage peut former des éléments de protection aux agressions environnementales: agressions foudres, perturbations électromagnétiques notamment, etc.

Le module de conversion des signaux d'entrée 33 permet de convertir les signaux analogiques reçus et éventuellement filtrés en des signaux numériques ou encore de mettre en forme de signaux de bus numériques en signaux exploitables par un coeur numérique de la plateforme 16A. Pour cela, des convertisseurs analogique/numérique et/ou d'autres moyens de mise en forme connus en soi peuvent être utilisés. Le module de conversion des signaux d'entrée 33 est apte donc à recevoir des signaux numériques via un ou plusieurs bus numériques et des signaux analogiques via une ou plusieurs entrées analogiques.

L'étage intermédiaire 22 comprend un module d'acquisition numérique 41, un module de traitement numérique 42, une zone de stockage 43 et un bus de communication 44.

Le module d'acquisition numérique 41 est connecté au module de conversion des signaux d'entrée 33 par un ou plusieurs bus et permet d'acquérir les signaux numériques fournis par ce module de conversion 33. En particulier, ce module 41 permet de faire trois types d'acquisition:
- les acquisitions des données numériques en entrée sur les différents bus numériques ; il peut par exemple s'agir de bus « legacy » de type ARINC 429 ou de bus spécifiques comme des lignes série de type RS485 ou Ethernet. Dans ce dernier cas, l'arrivée des données numériques se fait de façon asynchrone et non sollicitée par ce module 41. Pour gérer cet asynchronisme, le module d'acquisition numérique 41 peut effectuer une technique appelée « polling ». Cette technique est appliquée sur l'ensemble des bus à gérer de façon suffisamment rapide pour éviter la perte de données.
- les acquisitions d'informations numériques correspondant à des conversions analogiques / numériques. Dans ce cas les acquisitions sont pilotées par le module d'acquisition numérique 41 qui gère la configuration, le séquencement et l'acquisition de la conversion. Autrement dit, dans ce cas, les acquisitions se font de manière synchrone.
- les acquisitions de discrets d'entrée incluant une fonction de confirmation d'un changement d'état d'un discret d'entrée.

Le module de traitement numérique 42 est connecté au module d'acquisition numérique 41 et permet de traiter numériquement les données numériques acquises par ce module d'acquisition numérique 41.

Ce traitement peut être choisi en fonction des données numériques acquises et comprend par exemple :
- pour les données issues du module de conversion 33, des traitements de filtrage numériques pour réaliser l'extraction de valeurs physiques exploitables par les applications; ces traitements peuvent être constitués de filtres plus ou moins complexes pour assurer par exemple:
   - une conversion de signal selon le type et le niveau de précision attendu ;
   - un filtrage additionnel spécifique permettant aux applicatifs s'exécutant à basse fréquence de lire des valeurs filtrées en conséquence.
- des traitements de gestion de protocole typiquement pour les bus numériques, traitements qui consistent à extraire les informations utiles des signaux selon le protocole choisi pour ces bus.

La zone de stockage 43 permet de stocker au moins temporairement les données numériques produites par les module de traitement numérique 42. En particulier, le plus souvent une donnée après conversion correspondant à une entrée sera stockée à une adresse fixe ou dans une file de données. La manière de stockage est choisie avantageusement en fonction du type de la donnée (conversion analogique/numérique, donnée protocolaire, ...) et/ou le mode d'acquisition des données par le logiciel de base (accès direct aux entrées par le logiciel, serveur logiciel d'entrée / sorties...).

Le bus de communication 44 permet de transmettre ces données à l'étage final 23.

En particulier, ce bus de communication représente l'interface physique entre la partie logicielle et matérielle de la plateforme 16A. Les acquisitions de données par le logiciel se font donc par cette interface.

Avantageusement, le fonctionnement du module d'acquisition numérique 41 et de la zone de stockage 43 est contrôlé par une pluralité de paramètres. Ces paramètres sont par exemple stockés dans une base de données 46 faisant également partie de l'étage intermédiaire 22.

L'étage final 23 comprend une décomposition logique qui peut être choisie différemment selon l'implémentation choisie pour réaliser les acquisitions par le logiciel.

Par exemple, dans un modèle « client-serveur », l'étage final 23 comprend un processus d'acquisition des entrées 51 qui est asynchrone de l'utilisateur et qui acquiert les données issues du bus de communication 44 pour les stocker dans une mémoire tampon 52. L'étage final 23 comprend en outre un service client 53 permettant à l'application avionique 12 de faire l'acquisition des données depuis la mémoire tampon 52 de façon asynchrone.

Dans un autre modèle, les éléments 51, 52, 53 peuvent être vus comme un seul élément constituant alors l'étage final 23.

Selon l'invention, les plateformes de calcul 16A, 16B mettent en oeuvre au moins l'un des quatre mécanismes pour rendre les entrées de l'application avionique 12 fournies par le système de gestion 10 intègres. Il est à noter que chacun des mécanismes peut être mis en oeuvre indépendamment de chaque autre.

Selon un premier mécanisme, chacune des plateformes de calcul 16A, 16B comprend en outre un module de surveillance matérielle 61 et un module de surveillance logicielle 62. Ces modules 61, 62 seront expliqués ci-dessous en référence à la plateforme de calcul 16A et notamment à la figure 2.

Le module de surveillance matérielle 61 est configuré pour implémenter un test de fonctionnement de l'ensemble des étages 21, 22, 23, en injectant dans l'étage primaire 21 des signaux de test prédéterminés.

Pour ce faire, le module de surveillance matérielle 61 est connecté à l'étage primaire 21 et notamment au module de conversion des signaux d'entrée 31, pour injecter dans ce module 31 les signaux de test correspondants.

Les signaux de test prédéterminés correspondent à des signaux analogiques, des signaux numériques ou des signaux discrets.

En particulier, les signaux de test sous la forme des signaux numériques peuvent comprendre tout type de données numériques reçues sur un ou plusieurs bus réservés en entrée du module de conversion des signaux d'entrée 33. Les signaux de test sous la forme des signaux numériques permettent de couvrir toutes valeurs possibles sur un ou plusieurs bus numériques pour vérifier le décodage correct de n'importe quelle valeur notamment par le module de conversion des signaux d'entrée 33 et le traitement correct par le module de traitement numérique 42.

Les signaux de test sous la forme des signaux analogiques peuvent comprendre tout type de données analogiques possibles sur une ou plusieurs entrées analogiques du module de conversion des signaux d'entrée 33. Les signaux de test sous la forme des signaux analogiques permettent de couvrir toutes valeurs analogiques pour vérifier les différents types de filtrage numériques mis en oeuvre par le module de traitement numérique 42.

Les signaux de test sous la forme des signaux discrets permettent de tester le module d'acquisition numérique 41 et de confirmer des discrets d'entrée dans ce module.

Le module de surveillance logicielle 62 est configuré pour acquérir à partir de l'étage final 23 des données numériques correspondant aux signaux de test injectés par le module de surveillance matérielle 61 dans l'étage primaire 21, et pour vérifier leur correspondance à des valeurs prédéterminées. En particulier, ces valeurs prédéterminées sont déterminées à partir des signaux de test injectés par le module 61 et sont par exemple stockés dans le module de surveillance logicielle 62.

Encore plus particulièrement, le module de surveillance logicielle 62 est configuré pour vérifier au moins l'un des éléments suivants des données numériques acquises :
- authenticité ;
- datation ;
- intégrité ;
- valeur attendue.

Pour acquérir les données numériques correspondantes, le module de surveillance logicielle 62 est connecté à l'étage final 23 et notamment au service client 53 dans l'exemple de réalisation de la figure 2.

Le module de surveillance logicielle 62 est configuré en outre pour piloter le choix des signaux de test par le module de surveillance matérielle 61.

Les modules de surveillance logicielle 62 et de surveillance matérielle 61 sont implémentés selon des technologies différentes et indépendantes de celles des étages primaire 21, intermédiaire 22 et final 23.

En particulier, le module de surveillance matérielle 61 est implémenté dans un composant numérique totalement indépendant de chacun des éléments suivants :
- le bus de communication 44 ;
- le module de traitement numérique 42 ;
- la zone de stockage 43 ;
- le module d'acquisition numérique 41.

Le module de surveillance logicielle 62 est implémenté dans un composant logiciel indépendant des composants logiciels de l'étage final 23 et notamment du processus d'acquisition des entrées 51 et du service client 53.

Enfin, le module de surveillance matérielle 61 comprend une fonction de surveillance d'exécution des tests de fonctionnement des étages primaire 21, intermédiaire 22 et final 23. Le module de surveillance logicielle 62 est configuré pour réactiver périodiquement cette fonction de surveillance afin d'effectuer des tests de fonctionnement des étages 21 à 23.

Selon un deuxième mécanisme, l'étage intermédiaire 22 de chacune des plateformes de calcul 16A, 16B permet d'encapsuler chaque donnée numérique acquise et traitée respectivement par le module d'acquisition numérique 41 et le module de traitement numérique 42. Cette encapsulation est faite de façon à pouvoir vérifier au moins l'un des éléments suivants :
- la provenance de cette donnée (c'est-à-dire le module d'acquisition numérique 41 ou le module de traitement numérique 42) ;
- l'intégrité de cette donnée (notamment lors de sa transmission entre le module de traitement numérique 42 et sa réception par une application) ;
- la datation de cette donnée (notamment par exemple sa fraicheur).

Cette vérification est effectuée par exemple par une application de vérification 65 intégrée dans l'étage final 23 (par exemple dans le service client 53) ou dans l'application avionique 12, comme cela est illustré sur la figure 2.

L'encapsulation de chaque donnée est faite par exemple par le module de traitement numérique 42, par exemple, par formation d'un agrégat comprenant cette donnée (c'est-à-dire donnée utile) et au moins l'un des éléments suivants :
- un moyen d'authentification permettant d'authentifier la provenance de cette donnée ; et
- un moyen de datation permettant de dater cette donnée et/ou de mesurer sa fraicheur.

Le moyen d'authentification comprend par exemple une ou plusieurs données correspondant à un identifiant de l'entité ayant produit la donnée correspondante.

Le moyen de datation comprend par exemple une ou plusieurs données correspondant à la date de production de la donnée correspondante.

L'encapsulation de chaque donnée numérique peut comprendre en outre la formation d'une signature numérique de tout ou d'une partie de l'agrégat comprenant cette donnée (par exemple seul(s) du moyen d'authentification et/ou du moyen de datation). La signature numérique peut correspondre à un code de vérification CRC et peut être incluse dans l'agrégat pour être transmise avec la donnée.

Ainsi, à la réception de chaque donnée, l'application de vérification 65 est configurée pour vérifier la provenance, l'intégrité et la fraicheur de la donnée reçue. L'intégrité est vérifiée en utilisant la signature numérique.

L'application de vérification 65 peut être en outre configurée pour effectuer une décapsulation de la donnée correspondante. Autrement dit, l'application de vérification 65 peut être en outre configurée pour extraire la donnée utile de chaque agrégat correspondant et pour la transmettre ensuite à l'application correspondante.

Le deuxième mécanisme permet en particulier :
- d'authentifier une donnée d'un bus numérique après décodage protocolaire et ajouter une signature numérique à cette donnée pour vérifier l'intégrité complète de la donnée au niveau applicatif ;
- d'authentifier une donnée numérique issue de filtrages numériques (conversion de valeurs analogiques) et ajouter une signature numérique à cette donnée pour vérifier l'intégrité complète de la donnée au niveau applicatif ;
- de s'assurer qu'une donnée n'est pas figée et avec un rafraichissement cohérent des temps de rafraichissement du système 10.

Ce mécanisme permet donc de couvrir un erroné qui pourrait être introduit par la zone de stockage 43, le bus de communication 44 et éventuellement, par le processus d'acquisition des entrées 51, la mémoire tampon 52 et le service client 53.

Selon un troisième mécanisme, les étages primaires 21 des plateformes de calcul différentes 16A, 16B sont configurés pour être utilisés de façon dissymétrique.

En particulier, une telle utilisation de façon dissymétrique comprend au moins l'un des éléments suivants :
- attribution de points de connexion différents entre les différents connecteurs 31 ;
- attribution de chemins de routage et/ou de filtres analogiques différents entre les différents modules de filtrage analogique 32 ;
- utilisation dissymétrique des différents modules de conversion des signaux d'entrée 33.

Plus particulièrement, ce dernier élément peut comprendre l'utilisation dissymétrique des différents bus / entrées utilisés par ces modules 33.

Avantageusement, l'utilisation de façon dissymétrique des étages primaires 21 comprend au moins deux des éléments précités.

Selon un quatrième mécanisme, les modules d'acquisition numérique 41 des plateformes de calcul différentes 16A, 16B sont configurés pour être utilisés de façon dissymétrique.

Cette dissymétrie peut être introduite dans le séquencement des acquisitions des signaux issus du module de conversion des signaux d'entrée 33 entre les différentes plateformes de calcul 16A, 16B. Ce séquencement consiste par exemple :
- à faire les acquisitions par le module de conversion des signaux d'entrée 33 sur les bus numériques ;
- à effectuer les conversions analogique / numérique par le module de conversion des signaux d'entrée 33.

Ce séquencement peut être fait selon un ordre différent dans les différentes plateformes de calcul 16A, 16B.

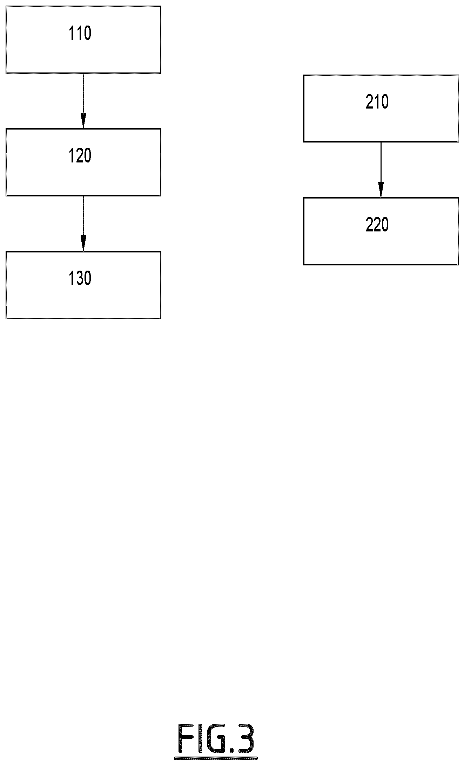

Un procédé de vérification de fonctionnement du système de gestion 10 sera désormais expliqué en référence à la figure 3 présentant un organigramme de ses étapes.

Ce procédé comprend la mise en oeuvre du premier mécanisme et du deuxième mécanisme indépendamment l'un de l'autre. Ainsi, seul l'un de ces deux mécanismes peut être mis en oeuvre. Il est par ailleurs considéré que le troisième mécanisme et/ou le quatrième mécanisme est(sont) mis en oeuvre de manière optionnelle lors de l'exécution de ce procédé.

En particulier, la mise en oeuvre du premier mécanisme comprend les étapes 110 à 130 et la mise en oeuvre du deuxième mécanisme comprend les étapes 210 à 220, expliquées ci-dessous.

Lors de l'étape 110, le module de surveillance matérielle 61 injecte dans l'étage primaire 21 des signaux de test prédéterminés. Comme expliqué précédemment, le choix de ces signaux peut être fait par le module de surveillance logicielle 62.

En outre, en fonction de la nature de ces signaux, ils peuvent être injectés via des bus numériques ou des entrées analogiques du module de conversion des signaux d'entrée 33.

Les signaux injectés transitent ensuite par l'étage intermédiaire 22 et l'étage final 23.

Lors de l'étape suivante 120, le module de surveillance logicielle 62 acquiert les données numériques correspondant aux signaux de test injectés et transités alors par les étages 22 et 23.

Lors de l'étape suivante 130, le module de surveillance logicielle 62 vérifie la correspondance de ces données numériques acquises à des valeurs prédéterminées.

En particulier, comme expliqué précédemment, ces valeurs prédéterminées peuvent vérifier l'authenticité, la datation, l'intégrité et/ou la valeur attendue des données numériques acquises.

Lors de l'étape 210, l'étage intermédiaire 22 et notamment le module de traitement numérique 42 fait une encapsulation de chaque donnée acquise par le module d'acquisition numérique 41 et éventuellement traitée le module 42.

Comme expliqué précédemment, cette encapsulation comprend notamment l'ajout d'un moyen d'authentification et/ou d'un moyen de datation. L'encapsulation peut comprendre en outre l'ajout d'une signature numérique.

Puis, la donnée encapsulée transite via le reste de l'étage intermédiaire 22 et l'étage final 23.

Lors de l'étape suivante 220, l'application de vérification 65 reçoit la donnée encapsulée et vérifie son encapsulation. En particulier, cette vérification peut comprendre la vérification de l'authenticité et/ou de la fraicheur et/ou de l'intégrité de cette donnée.

Puis, l'application de vérification 65 fait éventuellement une décapsulation de la donnée (i.e. extraction de la donnée utile de l'agrégat correspondant) avant de transmettre cette donnée à l'application avionique 12.

On conçoit alors que la présente invention présente un certain nombre d'avantages.

En particulier, le système de gestion selon l'invention met en oeuvre au moins l'un des mécanismes précités permettant de prouver l'intégrité de chaque donnée fournie à l'application avionique. Dans certains exemples, le système de gestion peut mettre en oeuvre au moins deux mécanismes ou au moins trois mécanisme. Encore dans certains exemples, le système de gestion met en oeuvre les quatre mécanismes.

Cela permet alors d'implémenter les différentes plateformes de calcul constituant un tel système de manière similaire au niveau matériel et logiciel. Cela permet ainsi de réduire considérablement le coût de développement et de maintenance de telles plateformes de calcul.

Bien entendu, d'autres exemples de réalisation du système de gestion tel que revendiqué sont également possibles.

## Revendications

1. Système de gestion d'entrées/sorties (10) d'au moins une application avionique (12) configurée pour générer au moins une consigne intègre, le système de gestion (10) comprenant au moins deux plateformes de calcul (16A, 16B) implémentées en utilisant des ressources matérielles et logicielles similaires, l'une des plateformes de calcul (16A, 16B) formant une chaine de commande et l'autre formant une chaine de surveillance, chaque plateforme de calcul (16A, 16B) comprenant :
- un étage primaire (21) configuré pour acquérir des signaux analogiques et les convertir en signaux numériques;
- un étage intermédiaire (22) configuré pour traiter numériquement les signaux numériques en formant des données numériques ;
- un étage final (23) configuré pour mettre à disposition de l'application avionique (12) les données numériques ;
- un module de surveillance matérielle (61) configuré pour implémenter un test de fonctionnement des étages primaire (21), intermédiaire (22) et final (23), en injectant dans l'étage primaire (21) des signaux de test prédéterminés ;
- un module de surveillance logicielle (62) configuré pour acquérir à partir de l'étage final (23) des données numériques correspondant aux signaux de test injectés par le module de surveillance matérielle (61) dans l'étage primaire (21), et pour vérifier leur correspondance à des valeurs prédéterminées.

2. Système (10) selon la revendication 1, dans lequel les signaux de test prédéterminés correspondent à des signaux analogiques, des signaux numériques ou des signaux discrets.

3. Système (10) selon la revendication 1 ou 2, dans lequel le module de surveillance logicielle (62) est configuré en outre pour piloter le choix des signaux de test par le module de surveillance matérielle (61).

4. Système (10) selon l'une quelconque des revendications précédentes, dans lequel le module de surveillance logicielle (62) est configuré pour vérifier la correspondance d'au moins l'un des éléments suivants des données numériques acquises à des valeurs prédéterminées :
- authenticité ;
- datation ;
- intégrité ;
- valeur attendue.

5. Système (10) selon l'une quelconque des revendications précédentes, dans lequel les modules de surveillance logicielle (62) et de surveillance matérielle (61) sont implémentés selon des technologies différentes et indépendantes de celles des étages primaire (21), intermédiaire (22) et final (23).

6. Système (10) selon l'une quelconque des revendications précédentes, dans lequel le module de surveillance matérielle (61) comprend une fonction de surveillance d'exécution des tests de fonctionnement des étages primaire (21), intermédiaire (22) et final (23), le module de surveillance logicielle (62) étant configuré pour réactiver périodiquement la fonction de surveillance.

7. Système (10) selon l'une quelconque des revendications précédentes, dans lequel les étages primaires (21) des plateformes de calcul différentes (16A, 16B) sont configurés pour être utilisés de façon dissymétrique.

8. Système (10) selon la revendication 7, dans lequel l'étage primaire (21) de chaque plateforme de calcul comprend un connecteur (31), un module de filtrage analogique (32) et un module de conversion des signaux d'entrée (33) ;
l'utilisation des étages primaires (21) des plateformes de calcul différentes (16A, 16B) de façon dissymétrique comprend au moins l'un des éléments suivants :
- attribution de points de connexion différents entre les différents connecteurs (31) ;
- attribution de chemins de routage et/ou de filtres analogiques différents entre les différents modules de filtrage analogique (32) ;
- utilisation dissymétrique des différents modules de conversion des signaux d'entrée (33).

9. Système (10) selon l'une quelconque des revendications précédentes, dans lequel l'étage intermédiaire (22) de chaque plateforme de calcul (16A, 16B) comprend un module d'acquisition numérique (41), les modules d'acquisition numérique (41) des plateformes de calcul différentes (16A, 16B) étant configurés pour être utilisés de façon dissymétrique.

10. Système (10) selon la revendication 9, dans lequel l'utilisation des modules d'acquisition numérique (41) des plateformes de calcul différentes (16A, 16B) de façon dissymétrique comprend un séquencement différent entre les acquisitions sur des bus numériques et les conversions analogique/numérique.

11. Système (10) selon l'une quelconque des revendications précédentes, dans lequel l'étage intermédiaire (22) de chaque plateforme de calcul (16A, 16B) comprend un module de traitement numérique (42) configuré pour encapsuler chaque donnée numérique de façon à pouvoir :
- vérifier par les autres modules de la plateforme la provenance de cette donnée ;
- vérifier par les autres modules de la plateforme l'intégrité de cette donnée ;
- vérifier par les autres modules de la plateforme la datation de cette donnée.

12. Procédé de vérification de fonctionnement d'un système de gestion (10) selon l'une quelconque des revendications précédentes ;
le procédé de vérification comprenant les étapes suivantes :
- injection dans l'étage primaire (21) des signaux de test prédéterminés ;
- acquisition à partir de l'étage final (23) des données numériques correspondant aux signaux de test injectés dans l'étage primaire (21) ; et pour
- vérification de la correspondance desdites données numériques à des valeurs prédéterminées.
